# EUROPEAN PATENT SPECIFICATION

(11) **EP 0 483 833 B1**
(45) Date of publication and mention of the grant of the patent: **07.01.1998**
(21) Application number: 91118570.0
(22) Date of filing: 30.10.1991
(51) Int. Cl.: H01L 27/02, H01L 27/118

(54) **Semiconductor integrated circuit device having cells with self-clamping terminal**
Integrierte Halbleiterschaltungsanordnung, die Zellen mit einem selbstklemmenden Anschluss enthält
Dispositif de circuit intégré semi-conducteur comprenant des cellules ayant un terminal auto-verrouillant

(30) Priority: 30.10.1990 JP 292880/90
(43) Date of publication of application: 06.05.1992
(73) Proprietor: NEC CORPORATION, Tokyo (JP)
(72) Inventor: Banno, Akihiro, Minato-ku, Tokyo (JP); Nakamura, Masahiro, Minato-ku, Tokyo (JP)
(74) Representative: Betten & Resch

(56) References cited:
- EP-A- 0 013 088
- EP-A- 0 177 336
- PATENT ABSTRACTS OF JAPAN vol. 13, no. 307 (E-787)(3655) 13 July 1989 & JP-A-1 082 545

## Description

### BACKGROUND OF THE INVENTION

### (1) Field of the Invention

The present invention relates to a semiconductor integrated circuit device and, more particularly, to an LSI of CPU core type standard cell custom.

### (2) Description of the Related Art

Among the standard cell custom LSIs, one called a custom LSI of CPU core type enables a user to construct a microcomputer suited to a desired purpose by freely and selectively combining logic functions of large scale cells provided in advance such as CPU, ROM, RAM, I/O port, serial I/O and timers, and combining gate cells provided in advance by the LSI makers. In this specification, such microcomputer is hereinafter referred to as a "custom microcomputer".

For designing such a custom microcomputer, the user relies on symbols for such as the CPU, ROM and RAM or symbols for basic cells provided by the maker to design a desired circuit by appropriately interconnecting them at his computer terminal (an Engineer Work Station, hereinafter referred to as an "EWS").

Where the symbols on an EWS circuit provided by the maker are only for 2-input, 3-input and 5-input NAND circuits, if the user desires to construct or design a 4-input NAND circuit, it is necessary for the user to use the 5-input NAND and apply constantly to one of the inputs not in use a signal which does not have influence on the circuit operation of the remaining four inputs, that is, for example, it is necessary to keep applying a high level signal in the case of a NAND circuit. A state wherein either a high level signal or a low level signal is constantly applied to an input terminal of a cell is hereinafter expressed as "clamped" or "clamping".

In a conventional custom microcomputer, it is necessary that, if a certain input terminal in the basic gate cell is not necessary for a given circuit operation, such input terminal should be clamped to either a high level or a low level. For this purpose, among the basic gate cells, one gate cell specifically for "clamping" is provided in advance by the maker, so that it is necessary for the user to design a desired circuit by combining such basic gate cell for clamping with other basic gate cells.

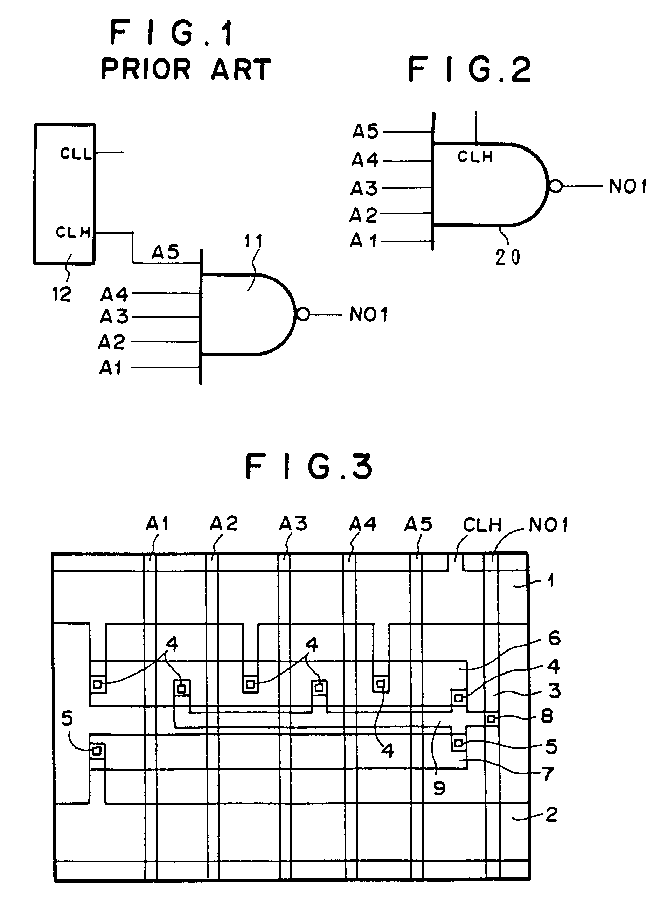

Fig. 1 shows the symbolic diagram on the EWS where the 5-input NAND is used for a 4-input NAND circuit. In Fig. 1, the numeral 11 represents the symbol designating the 5-input NAND. The numeral 12 represents the symbol designating a basic gate cell for clamping in the EWS, having a terminal CLH and a terminal CLL. From the terminal CLH and the terminal CLL, a high level signal and a low level signal are constantly being outputted, respectively. In the symbolic diagram of Fig. 1, the terminal CLH of the basic gate cell 12 for clamping and the terminal A5 of the NAND circuit 11 are connected with each other for the circuit to be a 4-input NAND circuit with the four input terminals A1 ∼ A4 being used.

In the conventional semiconductor integrated circuit device, if an input signal does not exist for a certain input terminal (A5, in the Fig. 1 example) in the basic gate cell in the custom microcomputer, it is necessary to clamp such unnecessary input terminal to a high level or a low level. Therefore, it is necessary for the user to design the circuit by selectively combining the clamping basic cell and other basic gate cells.

The circuit wherein a mask is laid-out based on the circuit diagram as explained above must be equipped with the basic cell for clamping and other basic gate cells which are connected to the basic cells for clamping and must have the necessary wirings for signals for clamping. This requires an area for accommodating such basic cell for clamping and such wirings for the other basic gate cells to be connected to the basic gate cell for clamping and this results in disadvantages due to the need of an increased area. Moreover, the increased area requires an increased length in the wiring of the circuitry of the semiconductor circuit device and results in a delay in an operating speed of the circuit.

Clamping cells of the type mentioned above are for example known by Patent Abstracts of Japan JP-A-1-82545, Vol. 13, No. 307, July 13, 1989.

EP-A-0 177 336 teaches clamping of a gate by connecting the gate either to a power supply line provided in a traverse channel or to an impurity diffusion region for avoiding the latch-up phenomenon.

The problem of the invention is to overcome the above described disadvantages of the conventional semiconductor devices and to provide an improved semiconductor integrated circuit device in which a separate basic cell for clamping purpose is unnecessary and its operation speed is increased.

The problem is solved by a semiconductor integrated circuit device as featured in claim 1. Further improvements of the invention are characterized in the dependent claims.

The above and other features and advantages of the present invention will be apparent from the following description of preferred embodiments of the invention explained with reference to the accompanying drawings, in which:
Fig. 1 is a symbolic diagram for an example of a conventional semiconductor integrated circuit;
Fig. 2 is a symbolic diagram for a 5-input NAND circuit on the EWS of a custom microcomputer as a first embodiment according to the invention;
Fig. 3 is a plan view of mask layout for the circuit of Fig. 2;
Fig. 4 is a symbolic diagram for a circuit wherein the user has made a desired connection in the circuit of Fig. 2;
Fig. 5 is a plan view of mask layout for the circuit of Fig. 4;
Fig. 6 is a symbolic diagram of a large scale cell on the EWS as a second embodiment according to the invention; and
Fig. 7 is a symbolic diagram for a circuit wherein the user has made a desired connection in the circuit of Fig. 6.

### PREFERRED EMBODIMENTS OF THE INVENTION

Now, an explanation is made on embodiments of the present invention with reference to the drawings.

Fig. 2 shows symbols representing a circuit on the EWS for a 5-input NAND circuit 20 and Fig. 3 shows an example of mask-layout in the 5-input NAND circuit 20 of Fig. 2 as a first embodiment of the present invention.

In Fig. 3, the symbols A1 ∼ A5 represent input terminals formed by polysilicon layers of the 5-input NAND circuit 20, which correspond to A1 ∼ A5 in Fig. 2, respectively.

The symbol NO1 represents an output terminal which corresponds to the same NO1 in Fig. 2. The numeral 1 represents the power supply region formed in an aluminum first layer and the numeral 2 represents the ground region formed in the aluminum first layer. The terminal CLH which corresponds to the CLH in Fig. 2 is connected to the power supply region 1 and is constantly outputting a high level signal. The numeral 3 represents an aluminum second layer wiring; 4 represents contacts between the aluminum first layer wirings and a P-type diffusion layer; 5 represents contacts between aluminum first layer wirings and an N-type diffusion layer; 6 represents the P-type diffusion layer; 7 represents the N-type diffusion layer; 8 represents a through-hole connecting the aluminum first layer wiring with the aluminum second layer wiring; and 9 represents the aluminum first layer wiring.

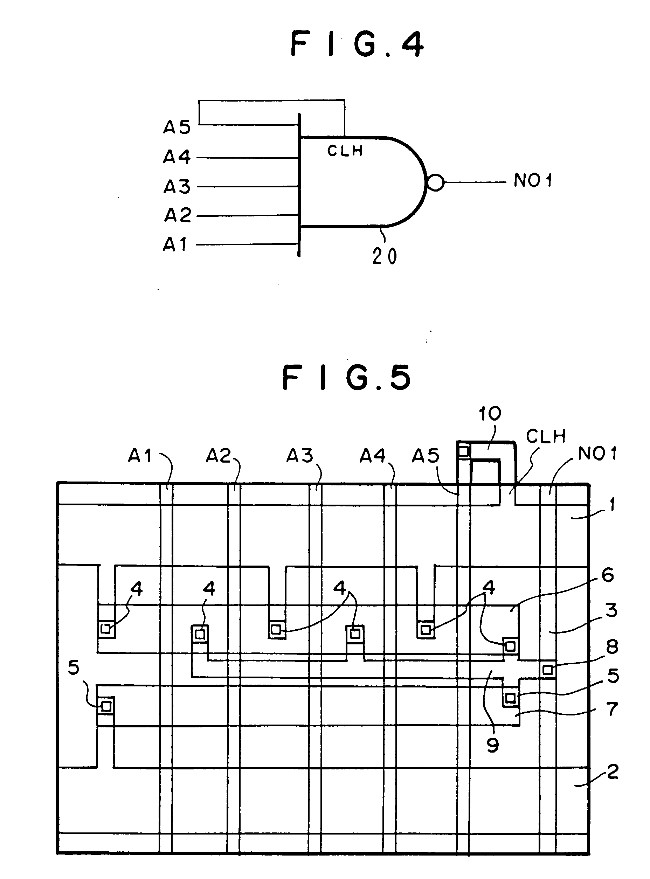

Fig. 4 shows a circuit diagram on the EWS for the user to design a 4-input NAND circuit 20 as desired by using the symbols on the EWS circuit diagram of the 5-input NAND circuit shown in Fig. 2. Fig. 5 shows the mask-layout designed based on the symbolic diagram of Fig. 4. As shown in Fig. 5, the input terminal A5 is connected with the wiring layer 10 so as to realize the 4-input NAND circuit 20 as desired by the user.

Since the clamping output terminal CLH and the input terminal A5 are connected with each other, a high level signal is constantly or always inputted to the terminal A5 thereby enabling the circuit to operate as a 4-input NAND circuit 20 with the input terminals A1 ∼ A4 being used.

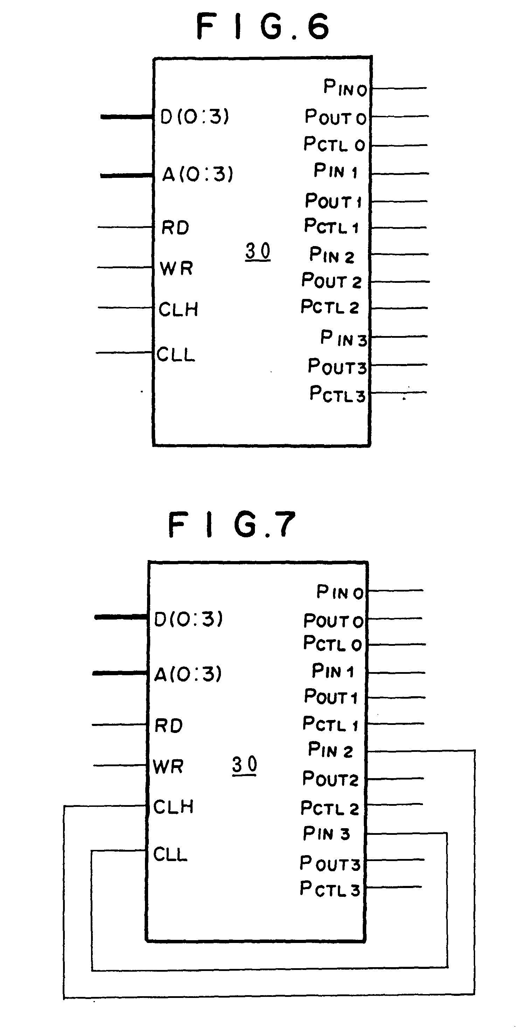

Next, an explanation is made on a second embodiment of the invention. Fig. 6 shows an example of symbols on the EWS circuit for I/O port 30 among the large scale cells in a custom microcomputer as the second embodiment of the invention.

Fig. 6 shows the I/O port 30 of 4 bits. P_{OUT0} ∼ P_{OUT3} are output terminals and P_{IN0} ∼ P_{IN3} are input terminals of the I/O port, and P_{CTL0} ∼ P_{CTL3} are output terminals of I/O control signals for effecting a change in each bit of the I/O port between an input mode and an output mode thereof.

Both as bundles of wirings, a symbol A(0:3) represents an address bus of 4 bits for the I/O port and a symbol D(0:3) represents a data bus. An RD is an output terminal for read signals and a WR is an output terminal for write signals. A CLH and a CLL are output terminals for clamping signals. The terminal CLH is constantly outputting a high level signal and the terminal CLL is constantly outputting a low level signal.

When designing a custom microcomputer using the symbols on the EWS circuit diagram for the I/O port as shown in Fig. 6, if the user needs only the bit 0 and the bit 1, for example, and does not need the bit 2 and the bit 3, it is necessary that an input signal of a fixed level be inputted to each of the input terminal P_{IN2} and the input terminal P_{IN3}.

Fig. 7 shows an EWS circuit diagram in which the input terminal P_{IN2} and the input terminal P_{IN3} are clamped to a high level and a low level, respectively.

The clamping output terminal CLH and the input terminal P_{IN2} are connected with each other, and the clamping terminal CLL and the input terminal P_{IN3} are connected with each other. Thus, when the mask is laid-out as shown in Fig. 7, it is possible to realize the mask-layout in which a high level signal is inputted to the terminal P_{IN2} and a low level signal is inputted to the terminal P_{IN3}.

As explained hereinabove, according to the present invention, the basic gate cells and the large scale cell themselves are equipped with the terminals for outputting clamping signals so that, where it is necessary to clamp certain terminals of the basic gate cells and the large scale cell to a fixed level, all that is necessary is to connect together such terminals for outputting the clamping signals and such input terminals as required to be clamped.

Therefore, it is possible to save the space to be occupied by the basic gate cell for clamping, and the wiring space needed for connecting the basic gate for clamping to other basic gate cells and/or to the large scale cell.

Moreover, as compared with a case wherein the basic cell for clamping is used, since the overall circuit area can be made small, the length of the necessary wirings in the semiconductor circuit device can also be made shorter thereby enabling the circuit to operate at a high speed.

## Claims

1. Semiconductor integrated circuit device in which a desired circuit was formed by connecting basic cells (20,30), the circuit comprising a large scale cell (30) designed in advance, and a plurality of basic gate cells (20) designed in advance, wherein at least some of said basic cells (20, 30) have unused input terminals,
characterized in that
at least one of said large scale cell and said plurality of basic gate cells have at least one clamping output terminal (CLH, CLL) for constantly outputting one of a high level clamping signal and a low level clamping signal.

2. Semiconductor integrated circuit device according to claim 1, characterized in
that the large scale cell (30) has a first clamping output terminal (CLH) for constantly outputting a high level signal and a second clamping output terminal (CLL) for constantly outputting a low level signal.

3. Semiconductor integrated circuit device according to claim 1 or 2, characterized in
that each of the plurality of basic gate cells has a clamping output terminal (CLH, CLL), for constantly outputting either of a high level signal and a low level signal.

4. Semiconductor integrated circuit device according to any one of claims 1 to 3, characterized in
that the large scale cell includes logic functions such as CPU, ROM, RAM, I/O port, serial I/O and timers.

## Patentansprüche

1. Integrierte Halbleiterschaltungsanordnung, in der eine gewünschte Schaltung durch das Verbinden von Basiszellen (20, 30) gebildet wurde, wobei die Schaltung eine vorher entwickelte LSI-Zelle (30) und eine Vielzahl von vorher entwickelten Basis-Gatterzellen (20) aufweist und wobei zumindest einige der Basiszellen (20, 30) unbenutzte Eingangsanschlüsse aufweisen,
dadurch gekennzeichnet, daß zumindest eine der LSI-Zellen und der Vielzahl von Basis-Gatterzellen zumindest einen Klemm-Ausgangsanschluß (CLH, CLL) aufweisen zur konstanten Ausgabe entweder eines Hochpegel-Klemmsignals oder eines Niederpegel-Klemmsignals.

2. Integrierte Halbleiterschaltung nach Anspruch 1, dadurch gekennzeichnet, daß die LSI-Zelle (30) einen ersten Klemm-Ausgangsanschluß (CLH) aufweist zur konstanten Ausgabe eines Hochpegelsignals sowie einen zweiten Klemm-Ausgangsanschluß (CLL) zur konstanten Ausgabe eines Niederpegelsignals.

3. Integrierte Halbleiterschaltung nach Anspruch 1 oder 2, dadurch gekennzeichnet, daß jede der Vielzahl von Basis-Gatterzellen einen Klemm-Ausgangsanschluß (CLH, CLL) aufweist zur konstanten Ausgabe von entweder einem Hochpegelsignal oder einem Niederpegelsignal.

4. Integrierte Halbleiterschaltung nach einem der Ansprüche 1 bis 3, dadurch gekennzeichnet, daß die LSI-Zelle logische Funktionen wie CPU, ROM, RAM, I/O-Port, serielle I/O und Zeitgeber einschließt.

## Revendications

1. Dispositif à circuit intégré à semiconducteurs dans lequel un circuit voulu a été formé en connectant des cellules de base (20, 30), le circuit comprenant une cellule à grande échelle (30) conçue d'avance, et une pluralité de cellules de portes de base (20) conçues d'avance, dans lequel au moins certaines desdites cellules de base (20, 30) comportent des bornes d'entrée inutilisées,
caractérisé en ce que au moins l'une de ladite cellule à grande échelle et ladite pluralité des cellules de portes de base comporte au moins une borne de sortie de verrouillage (CLH, CLL) pour délivrer constamment l'un parmi un signal de verrouillage de niveau haut et un signal de verrouillage de niveau bas.

2. Dispositif à circuit intégré à semiconducteurs selon la revendication 1, caractérisé en ce que la cellule à grande échelle (30) comporte une première borne de sortie de verrouillage (CLH) pour délivrer constamment un signal de niveau haut et une seconde borne de sortie de verrouillage (CLL) pour délivrer constamment un signal de niveau bas.

3. Dispositif à circuit intégré à semiconducteurs selon la revendication 1 ou 2, caractérisé en ce que chacune de la pluralité des cellules de portes de base comporte une borne de sortie de verrouillage (CLH, CLL) pour délivrer constamment l'un parmi un signal de niveau haut et un signal de niveau bas.

4. Dispositif à circuit intégré à semiconducteurs selon l'une quelconque des revendications 1 à 3, caractérisé en ce que la cellule à grande échelle comprend des fonctions logiques telles que d'unité CPU, de mémoire ROM, de mémoire RAM, de porte d'accès d'entrée/de sortie, d'entrée/de sortie en série et d'horloges.
